# EUROPEAN PATENT SPECIFICATION

(11) **EP 1 794 351 B1**
(45) Date of publication and mention of the grant of the patent: **31.10.2012**
(21) Application number: 05772093.0
(22) Date of filing: 18.07.2005
(51) Int. Cl.: C23C 22/52, C23C 22/83, C23F 1/18, H05K 3/38, C08G 12/32, C08G 12/42, C09D 5/12

(54) **MELAMINE-FORMALDEHYDE POST-DIP COMPOSITION FOR IMPROVING ADHESION OF METAL TO POLYMER**
MELAMIN-FORMALDEYHD-POST-DIP-ZUSAMMENSETZUNG ZUR VERBESSERUNG DER HAFTUNG VON METALL AUF POLYMER
COMPOSITION DE MELAMINE-FORMALDEHYDE POST-IMMERSION DESTINEE A AMELIORER L'ADHERENCE ENTRE METAL ET POLYMERE

(30) Priority: 30.09.2004 US 956912
(43) Date of publication of application: 13.06.2007
(73) Proprietor: MacDermid, Incorporated, Waterbury, CT 06702 (US)
(72) Inventor: FERRIER, Donald, R., Thomaston, CT 06787 (US)
(74) Representative: Jenkins, Peter David
(86) International application number: PCT/US2005/025259
(87) International publication number: WO 2006/038951

(56) References cited:
- US-A- 3 877 998
- US-A- 4 039 353
- US-A- 4 174 980
- US-A- 5 869 130
- US-A1- 2002 106 458

## Description

### FIELD OF THE INVENTION

The present invention is directed to a method of improving adhesion between metal and polymeric materials, particularly in the manufacture of multilayer printed circuit boards.

### BACKGROUND OF THE INVENTION

Printed circuits containing one or more circuitry innerlayers are in prominent use today as demand increases for further and further weight and space conservation in electronic devices.

In the typical fabrication of a multilayer printed circuit, patterned circuitry innerlayers are first prepared by a process in which a copper foil-clad dielectric substrate material is patterned with resist in the positive image of the desired circuitry pattern, followed by etching away of the exposed copper. Upon removal of the resist, there remains the desired copper circuitry pattern.

One or more circuitry innerlayers of any particular type or types of circuitry pattern, as well as circuitry innerlayers which might constitute ground planes and power planes, are assembled into a multilayer circuit by interposing one or more partially-cured dielectric substrate material layers (so-called "pre-preg" layers) between the circuitry innerlayers to form a composite of alternating circuitry innerlayers and dielectric substrate material. The composite is then subjected to heat and pressure to cure the partially-cured substrate material and achieve bonding of circuitry innerlayers thereto. The so-cured composite will then have a number of through-holes drilled therethrough, which are then metallized to provide a means for conductively interconnecting all circuitry layers. In the course of the through-hole metallizing process, desired circuitry patterns also typically will be formed on the outer-facing layers of the multilayer composite.

An alternate approach to the formation of a multilayer printed circuit board is through additive or surface laminer circuitry techniques. These techniques begin with a non-conductive substrate, upon which the circuit elements are additively plated. Further layers are achieved by repeatedly applying an imageable coating upon the circuitry and plating further circuit elements upon the imageable coating.

It has long been known that the strength of the adhesive bond formed between the copper metal of the circuitry innerlayers and the cured pre-preg layers, or other non-conductive coatings, in contact therewith leaves something to be desired, with the result that the cured multilayer composite or the coating is susceptible to delamination in subsequent processing and/or use. In response to this problem, various techniques have been developed for forming on the copper surfaces of the circuitry innerlayers (before assembling them with pre-preg layers into a multilayer composite) a layer of copper oxide, such as by chemical oxidation of the copper surfaces. The earliest efforts in this regard (so-called "black oxide" adhesion promoters) produced somewhat minimal improvement in the bonding of the circuitry innerlayers to the dielectric substrate layers in the final multilayer circuit, as compared to that obtained without copper oxide provision. Subsequent variations on the black oxide technique included methods wherein a black oxide coating is first produced on the copper surface, followed by post-treatment of the black oxide deposit with 15% sulfuric acid to produce a "red oxide" to serve as the adhesion promoter, such as disclosed by A. G. Osborne, "An Alternate Route To Red Oxide For Inner Layers", PC Fab. August, 1984, as well as variations involving direct formation of red oxide adhesion promoter, with varying degrees of success being obtained. The most notable improvement in this art is represented in U.S. Patent Nos. 4,409,037 and 4,844,981 to Landau, and involves oxides formed from relatively high chlorite/relatively low caustic copper oxidizing compositions, and producing substantially improved results in circuitry innerlayer adhesion.

As earlier noted, the assembled and cured multilayer circuit composite is provided with through-holes which then require metallization in order to serve as a means for conductive interconnection of the circuitry layers of the circuit. The metallizing of the through-holes involves steps of resin desmearing of the hole surfaces, catalytic activation, electroless copper depositing, electrolytic copper depositing, and the like. Many of these process steps involve the use of media, such as acids, which are capable of dissolving the copper oxide adhesion promoter coating on the circuitry innerlayer portions exposed at or near the through hole. This localized dissolution of the copper oxide, which is evidenced by formation around the through-hole of a pink ring or halo (owing to the pink color of the underlying copper metal thereby exposed), can in turn lead to localized delamination in the multilayer circuit.

This "pink ring" phenomenon is well-known in the art, and extensive effort has been extended in seeking to arrive at a multilayer printed circuit fabrication process that is not susceptible to such localized delamination. One suggested approach has been to provide the adhesion promoting copper oxide as a thick coating so as to retard its dissolution in subsequent processing simply by virtue of sheer volume of copper oxide present. However, this turned out to be essentially counter-productive, because the thicker oxide coating is inherently less effective as an adhesion promoter per se. Other suggestions relating to optimization of the pressing/curing conditions for assembling the multilayer composite have met with only limited success.

Other approaches to this problem have involved post-treatment of the copper oxide with an adhesion promoter coating prior to assembly of circuitry innerlayers and pre-preg layers into a multilayer composite. For example, U.S. Patent No. 4,775,444 to Cordani discloses a process in which the copper surfaces of the circuitry innerlayers are first provided with a copper oxide coating and then contacted with an aqueous chromic acid solution before the circuitry innerlayers are incorporated into the multilayer assembly. The treatment serves to stabilize and/or protect the copper oxide coating from dissolution in the acidic media encountered in subsequent processing steps (e.g. through-hole metallization), thereby minimizing pink ring/delamination possibilities.

U.S. Patent No. 4,642,161 to Akahoshi et al, U.S. Patent No. 4,902,551 to Nakaso et al, and U.S. Patent No. 4,981,560 to Kajihara et al, and a number of references cited therein, relate to processes in which the copper surfaces of the circuitry innerlayers, prior to incorporation of the circuitry innerlayers into a multilayer circuit assembly, are first treated to provide a surface coating of adhesion-promoting copper oxide. The copper oxide so formed is then reduced to metallic copper using particular reducing agents and conditions. As a consequence, the multilayer assembly employing such circuritry innerlayers does not evidence pink ring formation since there is no copper oxide present for localized dissolution, and localized exposure of underlying copper, in subsequent through-hole processing. As with the other techniques discussed above however, processes of this type are suspect in terms of the adhesion attainable between the dielectric substrate layers and the metallic copper circuitry innerlayers. This is particularly so in these reduction processes since the circuitry bonding surface not only is metallic copper, but also presents the metallic copper in distinct phases (i.e., (1) copper-from-reduction-of-copper oxide over (2) copper of the copper foil), which are prone to separation/delamination along the phase boundary.

U.S. Patent Nos. 4,997,722 and 4,997,516 to Adler similarly involve formation of a copper oxide coating on the copper surfaces of circuitry innerlayers, followed by treatment with a specialized reducing solution to reduce the copper oxide to metallic copper. Certain portions of the copper oxide apparently may not be reduced all the way to metallic copper (being reduced instead to hydrous cuprous oxide or cuprous hydroxide), and those species are thereafter dissolved away in a non-oxidizing acid, which does not attack or dissolve the portions already reduced to metallic copper. As such, the multi-layer assembly employing such circuitry innerlayers does not evidence pink ring formation since there is no copper oxide present for localized dissolution, and localized exposure of underlying copper, in subsequent through-hole processing. Again, however, problems can arise in terms of the adhesion between the dielectric layers and metallic copper circuitry innerlayers, firstly because the bonding surface is metallic copper, and secondly because the metallic copper predominately is present in distinct phases (i.e., (1) copper-from-reduction-of-copper oxide over (2) copper of the copper foil), a situation prone to separation/delamination along the phase boundary.

U.S. Patent No. 5,289,630 to Ferrier et al., reveals a process whereby an adhesion promoting layer of copper oxide is formed on the circuit elements followed by a controlled dissolution and removal of a substantial amount of the copper oxide in a manner which does not adversely affect the topography.

PCT Application No. WO 96/19097 to McGrath (and related U.S. Patent No. 5,800,859), describes a process for improving the adhesion of polymeric materials to a metal surface involving contacting the metal surface with an adhesion-promoting composition comprising hydrogen peroxide, an inorganic acid, a corrosion-inhibitor and a quaternary ammonium surfactant.

Likewise, U.S. Patent No. 5,869,130 to Ferrier discloses a process for improving the adhesion of a polymeric material to a metal surface involving treating metal surfaces with a composition comprising an oxidizer, an acid, a corrosion inhibitor, a source of halide ions and optionally a water soluble polymer.

U.S. Patent No. 6,554,948 to Ferrier describes an adhesion-promoting composition for improving the adhesion of polymeric materials to a metal surface, wherein the adhesion-promoting composition comprises an oxidizer, an acid, a corrosion inhibitor, a benzotriazole with an electron withdrawing group in the 1-position which electron withdrawing group is a stronger electron withdrawer than a hydrogen group, and optionally, a source of adhesion enhancing species selected from the group consisting of molybdates, tungstates, tantalates, niobates, vanadates, isopoly or heteropoly acids of molybdenum, tungsten, tantalum, niobium, vanadium, and combinations of any of the foregoing.

U.S. Patent Nos. 6,616,976, 6,743,303, and 6,752,878, all to Montano et al. attempt to improve the bonding between the polymer and metal surfaces by utilizing various post treatments subsequent to a conventional adhesion promotion composition. Each of these patents discusses a different post treatment - the 6,616,976 patent describes an epoxy resin composition, the 6,743,303 patent describes an organo-silicon wetting composition, and the 6,752,878 patent describes an aqueous wetting composition.

U.S. Patent No. 3,877,998 to Guhde describes treatment of ferrous metal, galvanized and aluminum surfaces with an aqueous solution of a melamine-formaldehyde composition.

As is readily seen, while numerous processes have been described for improving the bonding integrity between a metal surface and a polymeric material, there remains a need in the printed circuit board industry for additional improvements of the adhesive properties between metal and the polymeric material in the manufacture of printed circuit boards.

### SUMMARY OF THE INVENTION

It is an object of the present invention to improve the bonding integrity between a metal surface and a polymeric material, especially during the manufacture of printed circuit boards.

The present invention is directed to a process according to claim 1.

Preferred features are defined in the dependent claims.

Also described herein is an aqueous post-dip composition that is usable in the process of the invention. The melamine formaldehyde post-dip composition generally comprises an acid, a pH adjuster, and an effective amount of a melamine-formaldehyde reaction product.

The melamine-formaldehyde reaction product is typically formed by:
dissolving melamine in an aqueous formaldehyde solution;
adding an additive selected from the group consisting of triethanolamine, ethylene glycol, and methanol;
adding an acid selected from the group consisting of acetic acid and sulfuric acid;
diluting the solution with water; and
adjusting the pH of the solution with a pH adjuster.

### DETAILED DESCRIPTION OF THE PREFERRED EMBODIMENTS

The present invention is directed to a process for increasing the adhesion of a polymeric material to a metal surface comprising the steps of:
a) contacting the metal surface with an adhesion promoting composition comprising sulfuric acid, an oxidizer, and a corrosion inhibitor; and
b) thereafter contacting the metal surface with an aqueous amine formaldehyde polymer post-dip composition.

Thereafter, a polymeric material is bonded to the prepared metal surface.

The proposed process is particularly suited to the manufacture of multilayer printed circuit boards. The metal circuitry (usually copper) of the innerlayers is first treated with an appropriate adhesion-promoting composition. Thereafter, the metal circuitry is treated with the novel post-dip composition of the invention. After treatment, the innerlayers are bonded together with polymeric materials such as pre-pregs or imageable dielectrics, resulting in the multilayer printed circuit board.

The metal surface to be treated comprises copper or copper alloys. The polymeric material is selected from pre-preg materials, imageable dielectrics, photoimageable resins, soldermasks, adhesives and polymeric etch resists.

As discussed above, the metal surface is first contact with an adhesion-promoting composition, which typically comprises an acid, an oxidizer, and a corrosion inhibitor, to form a micro-roughened conversion coated surface.

The acid utilized in the adhesion-promoting composition may be any acid that is stable in the matrix, however, the inventors have found mineral acids to be particularly preferred. Sulfuric acid is especially preferred.

The oxidizer used in the adhesion-promotion composition may comprise any oxidizer that is capable of oxidizing the metal surface in the matrix of the adhesion-promotion composition. The inventors have found hydrogen peroxide and persulfates to be particularly preferred oxidizers for use in the process of the invention, with hydrogen peroxide being the most preferred oxidizer.

Corrosion inhibitors usable in the adhesion promotion composition may be any of a number of corrosion inhibitors that are commonly used in the art. Suitable corrosion inhibitors include, without limitation, triazoles, benzotriazoles, tetrazoles, imidazoles, benzimidazoles and mixtures of the foregoing. Benzotriazoles are particularly preferred.

The metal surface can be treated with the adhesion-promoting composition in a variety of ways, including immersion, spray, or flood. The temperature of the adhesion-promoting composition during treatment may range from 27°C to 66°C (80°F to 150°F) but is preferably from 32°C to 49°C (90°F to 120°F). The treatment time will vary depending upon the temperature and method of treatment but may range from 15 seconds to 15 minutes and is preferably from 1 to 2 minutes.

Once the metal surface has been treated with the adhesion-promoting composition, the metal surface is contacted with the aqueous post-dip composition of the invention.

The aqueous post-dip composition of the invention typically comprises:
a) phosphoric acid;
b) a pH adjuster; and
c) an effective amount of an amine formaldehyde reaction product polymer.

The amine-formaldehyde reaction product polymer is prepared by:
dissolving amine in an aqueous formaldehyde solution;
adding an additive selected from the group consisting of triethanolamine, ethylene glycol, and methanol;
adding an acid selected from the group consisting of acetic acid and sulfuric acid;
diluting the solution with water; and
adjusting the pH of the solution with a pH adjuster.

A suitable pH adjuster is sodium hydroxide, although other pH adjusters would also be known to those skilled in the art. Preferably, the amine-formaldehyde reaction product polymer is adjusted to a pH of 10 to 12 with sodium hydroxide. Preferably the amine used in the reaction for forming the polymer is melamine.

The aqueous post-dip composition is then prepared by mixing an effective amount of the amine-formaldehyde reaction product with phosphoric acid and a pH adjuster.

The pH of the aqueous post-dip solution is typically maintained between 5 and 14, preferably between 11 and 14, and more preferably between 12 and 13.

The temperature of the aqueous post-dip solution is typically maintained between 10 and 66°C (50 and 150°F), more preferably between 27 and 54°C (80 and 130°F), and more preferably between 43 and 49°C (110 and 120°F).

Once the metal surface has been treated with the adhesion-promoting composition and the aqueous post-dip composition of the invention, the metal surface may then be bonded to a polymeric material.

The following examples are illustrative of the invention but should not be taken as limiting.

The following commercial prepreg materials were used in the examples: Nelco® N4000-13 and N4000-11, available from Park Nelco; Getek® T-series Prepreg, available from Polyclad Laminates, Inc.; Hitachi® Halogen Free MCL-337G(N), available from Hitachi Chemical Co. America, Ltd.; and Isola® FR406, available from Isola Laminate Systems Corp.

### Example 1.

12.6 grams of melamine and 25 ml formaldehyde (37% aqueous solution) were gently boiled until the melamine was completely dissolved. The solution was cooled and 45 grams of triethanolamine was added with good mixing, and then 10 ml of glacial acetic acid was added. The mixture was held at about 71°C (about 160°F) with mixing for twenty minutes. The mixture was then cooled, diluted with water to 200 ml and the pH adjusted to approximately 12 with a 50% by weight solution of sodium hydroxide.

A post-dip composition was then prepared by neutralizing a solution of 20 ml/l phosphoric acid to a pH of 7.5 with a 50% by weight solution of sodium hydroxide, and then 25 ml/l of the melamine formaldehyde product was added. The final pH of the post-dip composition was about 8.3.

Copper clad panels and copper foils (35.6µm (1.4 mils) thickness) were cleaned and treated with an adhesion promoting composition of the type used for promotion of copper adhesion to polymer for printed circuit manufacture, comprising sulfuric acid, hydrogen peroxide, and benzotriazole. Approximately 1.14µm (45 microinches) of copper were removed in the adhesion promoting bath.

Following a rinse, some of the copper clad panels and copper foils were dried and the remaining copper clad panels and copper foils were processed through the melamine formaldehyde post-dip solution at room temperature for a period of about 1 minute, and then rinsed and dried.

The copper clad panels and foils were then baked and laminated with commercial prepreg materials. 2.54cm (one-inch) wide strips were formed on the foil side of these panels and peel strengths were measured after immersion in solder (288°C (550°F)) for zero, thirty, and sixty seconds. Peel strengths of the foils treated with the post-dip were compared with peel strengths obtained with foils treated in the same adhesion-promoting bath but with no post-dip treatment. The results are presented in Table 1.

**Table 1. Peel strengths of copper foils laminated with various prepreg materials after immersion in solder**

| **Prepreg Material** | **0 seconds solder kg/m (lb/inch)** | | **30 second solder kg/m (lb/inch)** | | **60 seconds solder kg/m (lb/inch)** | |
|---|---|---|---|---|---|---|
| | **No Post-dip** | **Post-dip** | **No Post-dip** | **Post-dip** | **No Post-dip** | **Post-dip** |
| Nelco® N4000-13 | 39.3 (2.2) | 75.0 (4.2) | 57.2 (3.2) | 80.4 (4.5) | 62.6 (3.5) | 80.4 (4.5) |
| Getek® T-series Prepeg | 92.9 (5.2) | 128.7 (7.2) | 44.7 (2.5) | 125.1 (7.0) | 26.8 (1.5) | 116.2 (6.5) |

### Example 2.

A post dip composition was prepared using the same melamine/formaldehyde resin as in example 1, but at a concentration of 6 ml/l and a pH of approximately 5.

Copper clad panels and foils were processed and peel strengths measured as discussed above for Example 1. The results are presented in Table 2.

**Table 2. Peel strengths of copper foils laminated with various prepreg materials after immersion in solder**

| **Prepreg Material** | **0 seconds solder kg/m (lb/inch)** | | **30 second solder kg/m (lb/inch)** | | **60 seconds solder kg/m (lb/inch)** | |
|---|---|---|---|---|---|---|
| | **No Post-dip** | **Post-dip** | **No Post-dip** | **Post-dip** | **No Post-dip** | **Post-dip** |
| Nelco® N4000-13 | 44.7 (2.5) | 67.9 (3.8) | 57.2 (3.2) | 67.9 (3.8) | 62.6 (3.5) | 71.5 (4.0) |
| Getek® T-series Prepeg | 116.2 (6.5) | 139.4 (7.8) | 57.2 (3.2) | 128.7 (7.2) | 39.3 (2.2) | 110.8 (6.2) |

### Example 3.

25.2 grams of melamine and 50 ml formaldehyde (37% aqueous solution) were gently boiled until the melamine was completely dissolved. The solution was cooled and 135 grams of triethanolamine was added with good mixing, and then 20 ml of glacial acetic acid was added with mixing. The mixture was heated at about 66 °C (about 150°F) with mixing for twenty minute. The mixture was then cooled, mixed with 100 ml water and the pH adjusted to approximately 10.5 with a 50% by weight solution of sodium hydroxide. The solution was then diluted to 500 ml.

A post-dip composition was made by neutralizing 20 ml/l phosphoric acid to a pH of about 12.0 with sodium hydroxide and then adding 40 ml/l of the melamine/formaldehyde reaction product. The temperature of the post-dip compositon was maintained at 49°C (120°F), and copper cores and foils were processed as described above in Example 1. The results are presented in Table 3.

**Table 3. Peel strengths of copper foils laminated with various prepreg materials after immersion in solder**

| **Prepreg Material** | **0 seconds solder kg/m (lb/inch)** | | **30 second solder kg/m (lb/inch)** | | **60 seconds solder kg/m (lb/inch)** | |
|---|---|---|---|---|---|---|
| | **No Post-dip** | **Post-dip** | **No Post-dip** | **Post-dip** | **No Post-dip** | **Post-dip** |
| Nelco® N4000-13 | 57.3 (3.2) | 128.7 (7.2) | 128.7 (7.2) | 134.1 (7.5) | 26.8 (1.5) | 53.6 (3.0) |
| Getek® T-series Prepeg | 128.7 (7.2) | 134.1 (7.5) | 71.5 (4.0) | 128.7 (7.2) | 44.7 (2.5) | 110.8 (6.2) |
| Hitachi® Halogen Free MCL-337G(N) | 26.8 (1.5) | 53.6 (3.0) | 26.8 (1.5) | 53.6 (3.0) | 32.2 (1.8) | 44.7 (2.5) |

### Example 4.

25.2 grams of melamine were mixed with 50 ml formaldehyde (37% aqueous solution) and then 6 drops of a 50% by weight solution of sodium hydroxide were added. The mixture was boiled until the melamine was completely dissolved. The solution was cooled and 200 grams of ethylene glycol was added with good mixing, and then 2 ml of glacial acetic acid was added with mixing. The mixture was maintained at a temperature of about 66°C (about 150°F) with mixing for twenty minutes. The mixture was then cooled and neutralized to a pH of approximately 11.5 with a 50% by weight solution of sodium hydroxide, and then diluted to 500 ml.

The post-dip composition was made by neutralizing 20 ml/l phosphoric acid to a pH of about 13.0 with sodium hydroxide and then adding 40 ml/l of the melamine/formaldehyde reaction product. The temperature of the post-dip composition was maintained at 49°C (120°F), and copper cores and foils were processed as described above in Example 1. The results are presented in Table 4.

**Table 4. Peel strengths of copper foils laminated with various prepreg materials after immersion in solder**

| **Prepreg Material** | **0 seconds solder kg/m (lb/inch)** | | **30 second solder kg/m (lb/inch)** | | **60 seconds solder kg/m (lb/inch)** | |
|---|---|---|---|---|---|---|
| | **No Post-dip** | **Post-dip** | **No Post-dip** | **Post-dip** | **No Post-dip** | **Post-dip** |
| Nelco® N4000-13 | 44.7 (2.5) | 85.8 (4.8) | 53.6 (3.0) | 92.9 (5.2) | 57.2 (3.2) | 98.3 (5.5) |
| Nelco® N4000-11 | 44.7 (2.5) | 71.5 (4.0) | 57.2 (3.2) | 67.9 (3.8) | 57.2 (3.2) | 67.9 (3.8) |
| Hitachi® Halogen Free MCL-337G(N) | 39.3 (2.2) | 53.6 (3.0) | 44.7 (2.5) | 53.6 (3.0) | 39.3 (2.2) | 53.6 (3.0) |

### Example 5.

The pH of the post-dip prepared in Example 4 was lowered to 12.4 and 20 ml/l of the melamine/formaldehyde reaction product was added. The temperature of the post-dip composition was maintained at about 49°C (about 120°F), and the copper cores and foils were processed as described in Example 1. The results are presented in Table 5.

**Table 5. Peel strengths of copper foils laminated with various prepreg materials after immersion in solder**

| **Prepreg Material** | **0 seconds solder kg/m (lb/inch)** | | **30 second solder kg/m (lb/inch)** | | **60 seconds solder kg/m (lb/inch)** | |
|---|---|---|---|---|---|---|
| | **No Post-dip** | **Post-dip** | **No Post-dip** | **Post-dip** | **No Post-dip** | **Post-dip** |
| Nelco® N4000-13 | 44.7 (2.5) | 98.3 (5.5) | 62.6 (3.5) | 92.9 (5.2) | 71.5 (4.0) | 89.4 (5.0) |
| Nelco® N4000-11 | 44.7 (2.5) | 75.0 (4.2) | 57.2 (3.2) | 75.0 (4.2) | 57.2 (3.2) | 71.5 (4.0) |
| Hitachi® Halogen Free MCL-337G(N) | 32.2 (1.8) | 71.5 (4.0) | 44.7 (2.5) | 75.0 (4.2) | 44.7 (2.5) | 57.2 (3.2) |

### Example 6.

25.2 grams of melamine were mixed with 50 ml formaldehyde (37% aqueous solution) and 2 ml of a 50% by weight solution of sodium hydroxide. The mixture was boiled until the melamine was completely dissolved. The solution was cooled and 200 grams of ethylene glycol was added with thorough mixing. Next, concentrated sulfuric acid was added to adjust the pH to 1 and the mixture was held at a temperature of 38°C (100°F) for one hour with occasional stirring. The mixture was then cooled and neutralized to a pH of approximately 12.0 with a 50% by weight solution of sodium hydroxide. The solution was then diluted to 500 ml.

The post-dip composition was made by neutralizing 20 ml/l phosphoric acid to a pH of about 12.4 with sodium hydroxide and then adding 40 ml/l of the melamine/formaldehyde reaction product. The temperature of the post-dip composition was maintained at 49 °C (120°F), and copper cores and foils were processed as described above in Example 1. The results are presented in Table 6.

**Table 6. Peel strengths of copper foils laminated with various prepreg materials after immersion in solder**

| **Prepreg Material** | **0 seconds solder kg/m (lb/inch)** | | **30 second solder kg/m (lb/inch)** | | **60 seconds solder kg/m (lb/inch)** | |
|---|---|---|---|---|---|---|
| | **No Post-dip** | **Post-dip** | **No Post-dip** | **Post-dip** | **No Post-dip** | **Post-dip** |
| Nelco® N4000-13 | 44.7 (2.5) | 89.4 (5.0) | 57.2 (3.2) | 85.8 (4.8) | 62.6 (3.5) | 80.4 (4.5) |
| Isola® FR406 | 85.8 (4.8) | 98.3 (5.5) | 53.6 (3.0) | 80.4 (4.5) | 32.2 (1.8) | 39.3 (2.2) |
| Hitachi® Halogen Free MCL-337G(N) | 32.2 (1.8) | 57.2 (3.2) | 44.7 (2.5) | 71.5 (4.0) | 44.7 (2.5) | 53.6 (3.0) |

### Example 7.

An additional 40 ml/l of the melamine/formaldehyde reaction product of Example 6 was added to the post-dip composition of Example 6. Copper cores and foils were processed as described above in Example 1. The results are presented in Table 7.

**Table 7. Peel strengths of copper foils laminated with various prepreg materials after immersion in solder**

| **Prepreg Material** | **0 seconds solder kg/m (lb/inch)** | | **30 second solder kg/m (lb/inch)** | | **60 seconds solder kg/m (lb/inch)** | |
|---|---|---|---|---|---|---|
| | **No Post-dip** | **Post-dip** | **No Post-dip** | **Post-dip** | **No Post- ' dip** | **Post-dip** |
| Nelco® N4000-13 | 44.7 (2.5) | 103.7 (5.8) | 57.2 (3.2) | 85.8 (4.8) | 62.6 (3.5) | 80.4 (4.5) |
| Isola® FR406 | 85.8 (4.8) | 98.3 (5.5) | 53.6 (3.0) | 92.3 (5.2) | 32.2 (1.8) | 57.2 (3.2) |
| Hitachi® Halogen Free MCL-337G(N) | 32.2 (1.8) | 53.6 (3.0) | 44. 7 (2.5) | 71.5 (4.0) | 44.7 (2.5) | 53.6 (3.0) |

### Example 8.

25.2 grams of melamine were mixed with 50 ml formaldehyde (37% aqueous solution) and 0.5 ml of a 50% by weight solution of sodium hydroxide was added. The mixture was boiled to dissolve the melamine and then cooled. 100 grams of methanol was added, and then concentrated sulfuric acid was added to adjust the pH to 1. The temperature of the mixture was held at 38°C (100°F) for one hour. The mixture was then cooled and neutralized to a pH of approximately 12.0 with a 50% by weight solution of sodium hydroxide. The solution was then diluted to 500 ml.

The post-dip composition was made by neutralizing 20 ml/l phosphoric acid to a pH of about 12.0 with sodium hydroxide and then adding 40 ml/l of the melamine/formaldehyde reaction product. The final pH of the post-dip composition was 12.4. The temperature of the post-dip composition was maintained at 49°C (120°F), and the copper cores and foils were processed as described above in Example 1. The results are presented in Table 8.

**Table 8. Peel strengths of copper foils laminated with various prepreg materials after immersion in solder**

| **Prepreg Material** | **0 seconds solder kg/m (lb/inch)** | | **30 second solder kg/m (lb/inch)** | | **60 seconds solder kg/m (lb/inch)** | |
|---|---|---|---|---|---|---|
| | **No Post-dip** | **Post-dip** | **No Post-dip** | **Post-dip** | **No Post dip** | **Post-dip** |
| Nelco® N4000-13 | 53.6 (3.0) | 92.3 (5.2) | 57.2 (3.2) | 107.2 (6.0) | 62.6 (3.5) | 98.3 (5.5) |
| Getek® T-series Prepeg | 116.2 (6.5) | 121.5 (6.8) | 62.6 (3.5) | 92.3 (5.2) | 32.2 (1.8) | 53.6 (3.0) |

### Example 9.

An additional 40 ml/l of the melamine/formaldehyde reaction product of Example 8 was added to the post-dip composition of Example 8 and the copper cores and foils were processed as described above in Example 1. The results are presented in Table 9.

**Table 9. Peel strengths of copper foils laminated with various prepreg materials after immersion in solder**

| **Prepreg Material** | **0 seconds solder kg/m (lb/inch)** | | **30 second solder kg/m (lb/inch)** | | **60 seconds solder kg/m (lb/inch)** | |
|---|---|---|---|---|---|---|
| | **No Post-dip** | **Post-dip** | **No Post-dip** | **Post-dip** | **No Post-dip** | **Post-dip** |
| Nelco® N4000-13 | 53.6 (3.0) | 110.8 (6.2) | 57.2 (3.2) | 107.2 (6.0) | 62.6 (3.5) | 98.3 (5.5) |
| Getek® T-series Prepeg | 116.2 (6.5) | 146.6 (8.2) | 62.6 (3.5) | 110.8 (6.2) | 32.2 (1.8) | 75.0 (4.2) |

### Comparative Example 1.

A post-dip composition was prepared from a 20 ml/l solution of phosphoric acid that was neutralized to pH 12.4. The temperature of the composition was maintained at 49°C (120°F).

The copper cores and foils were processed as described above in Example 1. The results are presented in Table 10.

**Table 10. Peel strengths of copper foils laminated with various prepreg materials after immersion in solder**

| **Prepreg Material** | **0 seconds solder kg/m (lb/inch)** | | **30 second solder kg/m (lb/inch)** | | **60 seconds solder kg/m (lb/inch)** | |
|---|---|---|---|---|---|---|
| | **No Post-dip** | **Post-dip** | **No Post-dip** | **Post-dip** | **No Post-dip** | **Post-dip** |
| Nelco® N4000-13 | 53.6 (3.0) | 57.2 (3.2) | 57.2 (3.2) | 80.4 (4.5) | 62.6 (3.5) | 85.8 (4.8) |
| Getek® T-series Prepeg | 116.2 (6.5) | 50.0 (2.8) | 62.6 (3.5) | 21.4 (1.2) | 32.2 (1.8) | 14.3 (0.8) |
| Hitachi® Halogen Free MCL-337G(N) | | 44.7 (2.5) | | 62.6 (3.5) | | 67.9 (3.8) |

As is readily seen from the examples, the post-dip composition of the invention improves the metal-to-polymer adhesion for a number of prepeg materials under a variety of operating conditions. The metal-to-polymer adhesion is improved above any benefit provided by the strong alkaline environment itself.

## Claims

1. A process for the manufacture of multilayer printed circuit boards, the process comprising the steps of:
a) contacting a metal surface comprising copper or copper alloys with an adhesion promoting composition comprising an acid, an oxidizer, and a corrosion inhibitor to form a micro-roughened surface;
b) contacting the micro-roughened surface with an aqueous amine-formaldehyde polymer post-dip composition; and
c) bonding a polymeric material to the treated metal surface, wherein the polymeric material is selected from pre-preg materials, imageable dielectrics, photoimageable resins, soldermasks, adhesives or polymeric etch resists.

2. The process according to claim 1, wherein the corrosion inhibitor of the adhesion promoting composition comprises a benzotriazole.

3. The process according to claim 1, wherein the metal surface is contacted with the corrosion inhibitor by immersion.

4. The process according to claim 1, wherein the amine formaldehyde polymer post-dip composition comprises:
phosphoric acid;
a pH adjuster; and
an effective amount of an amine-formaldehyde reaction product polymer,
wherein the pH adjuster is sodium hydroxide.

5. The process according to claim 1, comprising forming the amine-formaldehyde reaction product by:
dissolving amine in an aqueous formaldehyde solution;
adding an additive selected from the group consisting of triethanolamine, ethylene glycol, and methanol;
adding an acid selected from the group consisting of acetic acid and sulfuric acid;
diluting the solution with water; and
adjusting the pH of the solution with a pH adjuster, wherein the pH adjuster is sodium hydroxide.

6. The process according to claim 5, wherein the amine-formaldehyde reaction product is adjusted to a pH of 10 to 12.

7. The process according to claim 5, wherein the pH of the aqueous post-dip solution is between 5 and 14.

8. The process according to claim 7, wherein the pH of the aqueous post-dip solution is between 11 and 14.

9. The process according to claim 8, wherein the pH of the aqueous post-dip solution is between 12 and 13.

10. The process according to any one of claims 1, 5 or 6 wherein the amine comprises melamine.

## Patentansprüche

1. Verfahren zur Herstellung von Mehrlagenleiterplatten, wobei das Verfahren die Schritte:
a) Kontaktieren einer Metalloberfläche, umfassend Kupfer oder Kupferlegierungen, mit einer adhäsionsbeschleunigenden Zusammensetzung, umfassend eine Säure, ein Oxidationsmittel und einen Korrosionsinhibitor, unter Bildung einer mikro-aufgerauten Oberfläche;
b) Kontaktieren der mikro-aufgerauten Oberfläche mit einer wässerigen Amin-Formaldehyd-Polymer-Nachtauch-Zusammensetzung und
c) Binden eines polymeren Materials an die behandelte Metalloberfläche, wobei das polymere Material aus Prepregmaterialien, abbildbaren Dielektrika, photoabbildbaren Harzen, Lötmasken, Klebstoffen oder polymeren Ätzmasken ausgewählt ist,
umfasst.

2. Verfahren nach Anspruch 1, wobei der Korrosionsinhibitor der adhäsionsbeschleunigenden Zusammensetzung ein Benzotriazol umfasst.

3. Verfahren nach Anspruch 1, wobei die Metalloberfläche mit dem Korrosionsinhibitor durch Eintauchen kontaktiert wird.

4. Verfahren nach Anspruch 1, wobei die Amin-Formaldehyd-Polymer-Nachtauch-Zusammensetzung:
Phosphorsäure;
ein pH-Einstellmittel und
eine wirksame Menge eines Amin-Formaldehyd-Reaktionsprodukt-Polymers umfasst, wobei das pH-Einstellmittel Natriumhydroxid ist.

5. Verfahren nach Anspruch 1, umfassend das Bilden Amin-Formaldehyd-Reaktionsproduktes durch:
Lösen von Amin in einer wässerigen Formaldehydlösung;
Zugeben eines Additivs, ausgewählt aus der Gruppe, bestehend aus Triethanolamin, Ethylenglycol und Methanol;
Zugeben einer Säure, ausgewählt aus der Gruppe, bestehend aus Essigsäure und Schwefelsäure;
Verdünnen der Lösung mit Wasser und
Einstellen des pH der Lösung mit einem pH-Einstellmittel, wobei das pH-Einstellmittel Natriumhydroxid ist.

6. Verfahren nach Anspruch 5, wobei das Amin-Formaldehyd-Reaktionsprodukt auf einen pH von 10 bis 12 eingestellt wird.

7. Verfahren nach Anspruch 5, wobei der pH der wässerigen Nachtauchlösung zwischen 5 und 14 liegt.

8. Verfahren nach Anspruch 7, wobei der pH der wässerigen Nachtauchlösung zwischen 11 und 14 liegt.

9. Verfahren nach Anspruch 8, wobei der pH der wässerigen Nachtauchlösung zwischen 12 und 13 liegt.

10. Verfahren nach einem der Ansprüche 1, 5 oder 6, wobei das Amin Melamin umfasst.

## Revendications

1. Procédé de fabrication de cartes de circuit imprimé multicouche, le procédé comprenant les étapes suivantes :
a) mettre en contact une surface métallique comprenant du cuivre ou des alliages de cuivre avec une composition favorisant l'adhérence comprenant un acide, un oxydant et un inhibiteur de corrosion pour former une surface micro-rugueuse ;
b) mettre en contact la surface micro-rugueuse avec une composition de post-trempage de polymère amine-formaldéhyde ; et
c) faire adhérer un matériau polymère sur la surface métallique traitée, le matériau polymère étant sélectionné parmi des matériaux de pré-imprégnation, des diélectriques impressionnables, des résines photosensibles, des masques de soudure, des adhésifs ou des résines de gravure polymères.

2. Procédé selon la revendication 1, dans lequel l'inhibiteur de corrosion de la composition favorisant l'adhérence comprend benzotriazole.

3. Procédé selon la revendication 1, dans lequel la surface métallique est mise en contact avec l'inhibiteur de corrosion immersion.

4. Procédé selon la revendication 1, dans lequel la composition de post-trempage polymère amine-formaldéhyde comprend :
de l'acide phosphorique ;
un ajusteur de pH ; et
une quantité effective d'un polymère produit de réaction amine-formaldéhyde, dans lequel l'ajusteur de pH est de l'hydroxyde de sodium.

5. Procédé selon la revendication 1, comprenant la formation du produit de réaction amine-formaldéhyde par les étapes suivantes :
dissoudre de l'amine dans une solution aqueuse de formaldéhyde ;
ajouter un additif sélectionné dans le groupe comprenant la triéthanolamine, l'éthylène glycol et le méthanol ;
ajouter un acide sélectionné dans le groupe comprenant l'acide acétique et l'acide sulfurique ;
diluer la solution avec de l'eau ; et
ajuster le pH de la solution avec ajusteur de pH, l'ajusteur de pH étant de l'hydroxyde de sodium.

6. Procédé selon la revendication 5, dans lequel le produit de réaction amine-formaldéhyde est ajusté à un pH de 10 à 12.

7. Procédé selon la revendication 5, dans lequel le pH de la solution aqueuse de post-trempage est compris entre 5 et 14.

8. Procédé selon la revendication 7, dans lequel le pH de la solution aqueuse de post-trempage est compris entre 11 et 14.

9. Procédé selon la revendication 8, lequel le pH de la solution aqueuse de post-trempage est compris entre 12 et 13.

10. Procédé selon l'une quelconque revendication 1, 5 ou 6, lequel l'aminé comprend de la mélamine.
